# FASCICULE DE BREVET EUROPEEN

(11) **EP 4 203 315 B1**
(45) Date de publication et mention de la délivrance du brevet: **30.07.2025**
(21) Numéro de dépôt: 22214899.1
(22) Date de dépôt: 20.12.2022
(51) Int. Cl.: H03K 17/082, H03K 17/16

(54) **COMMUTATEUR ET DISPOSITIF ÉLECTRONIQUE ASSOCIÉ**
SCHALTER UND ELEKTRONISCHE VORRICHTUNG DAFÜR
SWITCH AND ELECTRONIC DEVICE THEREOF

(30) Priorité: 21.12.2021 FR 2114066
(43) Date de publication de la demande: 28.06.2023
(73) Titulaire: Commissariat à l'Energie Atomique et aux Energies Alternatives, 75015 Paris (FR)
(72) Inventeur: DELAINE, Johan, 38054 GRENOBLE CEDEX 9 (FR)
(74) Mandataire: Lavoix

(56) Documents cités:
- US-A1- 2006 126 253
- US-A1- 2011 148 376

## Description

La présente invention concerne un commutateur. Elle se rapporte également à un dispositif électronique comportant un tel commutateur.

Certains types de transistors de puissance à commutation rapide subissent des phénomènes d'auto-commutation dû à l'effet Miller. De tels phénomènes apparaissent lorsque la tension entre le drain et la source du transistor de puissance augmente rapidement induisant au passage une potentielle montée de la tension de grille pouvant mener à une remise en conduction et un court-circuit temporaire.

Pour remédier à ce problème, il est connu plusieurs solutions dans l'état de la technique.

Le document WO201984899 A1 propose un circuit de pilotage d'un commutateur, le circuit de pilotage comprenant un capteur de tension servant à détecter une tension de pilotage une source électrique servant à fournir un signal de pilotage ayant une valeur de pilotage. Le circuit de pilotage est conçu pour régler la valeur de pilotage sur la base de la tension de pilotage afin de limiter un courant de commutation circulant à travers le commutateur.

Un tel circuit permet de supprimer les remontées de grilles, mais au détriment de pertes par commutation.

Il existe aussi des techniques proposant des procédés de fabrication de transistors visant à ajuster les valeurs des capacités entre les électrodes du transistor pour entraîner une meilleure immunité naturelle.

Toutefois, une telle technique est relativement complexe à mettre en œuvre.

Il est également connu d'autres techniques des documents US 2011/148376 A1 et US 2006/126253 A1.

Il existe donc un besoin pour un commutateur prémuni au moins en partie contre l'effet Miller avec une technique qui soit de mise en œuvre aisée.

A cet effet, la description décrit un commutateur selon les caractéristiques de la revendication indépendante 1.

Selon des modes de réalisation particuliers, le commutateur présente une ou plusieurs des caractéristiques suivantes, prise(s) isolément ou selon toutes les combinaisons techniquement possibles :
- le circuit de liaison est un condensateur.
- le transistor à protéger est réalisé en nitrure de gallium ou en carbure de silicium.
- l'unité de protection et le transistor à protéger sont réalisés sur une même puce.
- chaque transistor présente une dimension, le rapport entre la dimension du transistor de protection et la dimension du transistor à protéger étant inférieur ou égal à 0,1.

La description décrit également un dispositif électronique comportant un commutateur tel que précédemment décrit.

Selon un mode de réalisation particulier, le dispositif électronique comporte, en outre, une source de tension et un bras de pont formé par un transistor et le commutateur.

Des caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un exemple de commutateur qui n'est pas revendiqué dans le jeu de revendications actuel mais qui est utile pour la compréhension de l'invention,
- la figure 2 est une représentation schématique d'un autre exemple de commutateur, et
- la figure 3 est une représentation schématique d'un dispositif électronique comprenant un commutateur selon la figure 1 ou 2.

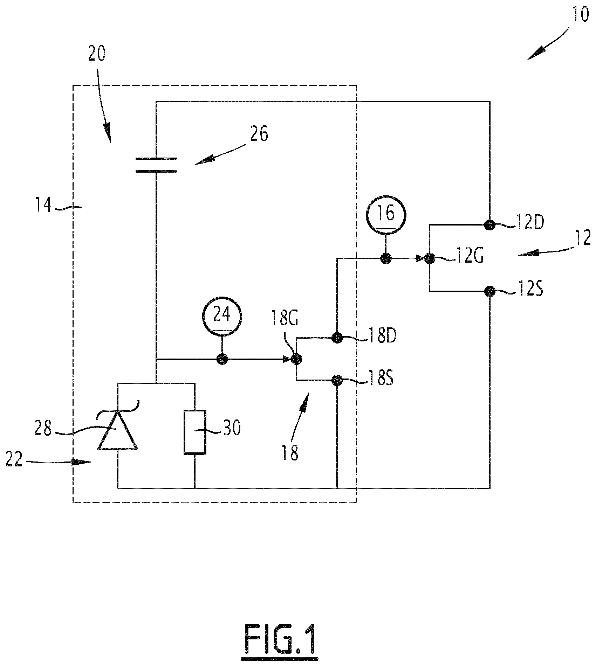

Un exemple de commutateur 10 est représenté schématiquement sur la figure 1.

Un commutateur 10 est, par définition, un composant électronique propre à commuter.

Le commutateur 10 comporte un transistor à protéger 12 et une unité de protection 14 contre l'effet Miller.

Selon l'exemple décrit, le transistor à protéger 12 et l'unité de protection 14 sont réalisés sur la même puce.

Autrement formulé, l'unité de protection 14 est intégrée de façon monolithique avec le transistor à protéger 12 pour former un composant unique qui est le commutateur 10 qui correspond finalement à un transistor à effet Miller contrôlé.

Le transistor à protéger 12 est sujet à l'effet Miller. Cela signifie généralement que le transistor présente une vitesse de commutation très élevée, c'est-à-dire une vitesse de commutation supérieure ou égale à 50kV/µs.

Le transistor à protéger 12 est, par exemple un transistor à haute mobilité électronique (plus souvent désigné sous l'acronyme HEMT qui renvoie à la dénomination anglaise correspondante de « *High Electron Mobility Transistor* »)*.*

En variante, le transistor à protéger 12 est un transistor bipolaire à grille isolée (plus souvent désigné sous l'acronyme IGBT qui renvoie à la dénomination anglaise correspondante de « *Insulated Gate Bipolar Transistor* »).

Le transistor à protéger 12 est, par exemple, réalisé en nitrure de Gallium (GaN) ou en Carbure de Silicium (SiC).

Le transistor à protéger 12 comporte trois électrodes, une grille 12G, un drain 12D et une source 12S.

La grille 12G du transistor à protéger 12 est alimentée par une tension de commande 16.

L'unité de protection 14 vise à protéger le transistor à protéger 12 contre l'effet Miller.

Une telle protection peut être absolue ou relative, c'est-à-dire que l'unité de protection 14 peut réduire ou annuler l'effet Miller selon les cas, c'est-à-dire diminuer au moins en partie l'amplitude de l'effet Miller.

L'unité de protection 14 pourrait ainsi être qualifié de « circuit de Miller clamp » comme l'appellation est parfois utilisée.

L'unité de protection 14 comporte un transistor de protection 18, un circuit de liaison 20 et un circuit de commande 22.

Le transistor de protection 18 comporte également trois électrodes, à savoir une grille 18G, un drain 18D et une source 18S.

Le transistor de protection 18 est tel que le transistor de protection 18 présente une taille bien inférieure à celle du transistor à protéger 12.

La taille d'un transistor est, par exemple, définie comme la surface occupée par le transistor sur la puce sur laquelle est réalisé le transistor dans la technologie de fabrication choisie.

Alternativement, la taille d'un transistor peut également être obtenue en mesurant la valeur de l'état passant du transistor considéré. En effet, la valeur de l'état passant d'un transistor est liée à la surface occupée par la grille du transistor.

Ainsi, le rapport entre dimension du transistor de protection 18 et la dimension du transistor à protéger 12 est inférieur ou égal à 0,1.

En outre, le transistor de protection 18 présente un état passant ayant une valeur inférieure à l'impédance de la capacité C_{GS} à la fréquence équivalente du front de tension drain-source (capacité entre la grille 12G et la source 12S) du transistor à protéger 12.

Le drain 18D du transistor de protection 18 est relié à la grille 12G du transistor à protéger 12.

Par l'expression « relié », il est ici entendu le fait que le potentiel du drain 18D transistor de protection 18 et le potentiel de la grille 12G du transistor à protéger 12 sont identiques grâce à un élément conducteur reliant les deux électrodes.

La source 18S du transistor de protection 18 est également reliée à la source 12S du transistor à protéger 12.

La grille 12G du transistor à protéger 12 est reliée à un premier clamp de grille 16 et similairement, la grille 18G du transistor de protection 18 est reliée à un deuxième clamp de grille 24, les deux clamps de grille 16 et 24 étant distincts.

Un clamp de grille sert à clamper la tension entre la grille et la source, c'est-à-dire à la limiter.

En l'espèce, chaque clamp de grille 16 ou 24 comporte un transistor.

Contrairement à une diode conventionnelle qui ne laisse passer le courant électrique que dans un seul sens, le sens direct, les diodes Zener sont conçues de façon à laisser également passer le courant inverse, mais ceci uniquement si la tension à ses bornes est plus élevée que le seuil de l'effet d'avalanche.

Selon l'exemple proposé, la diode Zener présente une tension Zener égale à la tension de commande du transistor de protection 18.

Par exemple, la tension de commande d'un transistor de protection 18 qui est un HEMT en GaN s'élève à 5 Volts (V).

Selon un autre exemple, pour un transistor de protection 18 qui est un MOSFET (acronyme qui renvoie à la dénomination anglaise de *« Metal Oxide Semiconductor Field Effect Transistor* » qui se traduit par transistor à effet de champ à structure métal-oxyde-semiconducteur) en SiC, la tension de commande est comprise entre 10V et 20V.

Le circuit de liaison 20 bloque la circulation de courant continu ou basse fréquence. Ainsi, le circuit de liaison 20 permet une circulation de courant haute frequence vers le circuit de commande 22.

En ce sens, le circuit de liaison 20 est un filtre passe-haut pour le courant de fuite du transistor à protéger 12.

Cela permet d'éviter les fuites au niveau du transistor à protéger 12.

Dans le cas décrit, le circuit de liaison 20 est un condensateur 26 disposé entre la grille 18G du transistor de protection 18 et le drain 12D du transistor à protéger 12.

Plus précisément, une borne du condensateur 26 est reliée au potentiel appliqué à la grille 18G du transistor de protection 18 et l'autre borne du condensateur 26 est reliée au potentiel appliqué au drain 12D du transistor à protéger 12.

La capacité du condensateur 26 est adaptée en fonction de la dimension du transistor de protection 18.

A titre d'exemple, pour un transistor à protéger 12 qui présente une résistance dans un état passant de 50 mΩ (permettant à ce transistor de supporter 30 A) et un transistor de protection 18 présentant une résistance dans l'état passant de 500 mΩ pour une capacité entre la grille 18G et le drain 18D de 8 pF, la capacité du condensateur 26 peut être choisie à une valeur de 9 pF.

Le circuit de commande 22 sert à décharger (respectivement charger) le transistor de protection 18 et plus spécifiquement à décharger (charger) la grille 18G du transistor de protection 18.

Le circuit de commande 22 est intercalé entre la grille 18G du transistor de protection 18 et la source 12S du transistor à protéger 12.

Pour le cas de la figure 1, le circuit de commande 22 est formé par une diode Zener 28 en parallèle avec une résistance 30.

La diode Zener 28 est reliée d'une part au potentiel appliqué à la grille 18G du transistor de protection 18 et reliée d'autre part à la source 12S du transistor à protéger 12. La diode Zener 28 est reliée de manière à être dans l'état bloqué en présence d'un tension positive entre la grille 18G du transistor de protection 18 et la source 12S du transistor à protéger 12.

Similairement, la résistance 30 est reliée par une de ses bornes au potentiel appliqué à la grille 18G transistor de protection 18 et relié par l'autre de ses bornes à la source 12S du transistor à protéger 12.

La valeur de la résistance 30 est comprise entre 100 Ω et 1000 Ω. Une telle valeur permet de conférer une bonne capacité de décharge à la résistance 30.

Pour donner un ordre de grandeur de l'ensemble des valeurs des composants pouvant être utilisés pour le commutateur 10, à titre d'exemple particulier, pour protéger un transistor ayant comme caractéristiques électriques respectivement 650 V (tension de claquage), 30 A (calibre en courant) et 50 mΩ (résistance dans l'état passant), le condensateur 26 présente une capacité de 11 pF, la résistance 30 présente une résistance de 1000 Ωet la diode Zéner 28 présente un courant maximal à 3A et un courant efficace de 120 mA à 1 MHz.

Le fonctionnement du circuit de protection 14 est maintenant décrit.

L'effet Miller provient d'une variation de la tension entre le drain 12D et la source 12S du transistor à protéger 12 avec une fréquence équivalente importante.

Il est utilisé le transistor de protection 18 pour maintenir la tension entre la grille 12G et la source 12S à zéro.

Il est exploité l'origine de l'effet pour piloter le transistor de protection 18 avec un diviseur de tension consistant de base en un condensateur 26 et une résistance 30.

Le condensateur 26 ne laisse pas passer de courant continu ou à basse fréquence. Cela évite les fuites au niveau du transistor à protéger 12.

Le condensateur 26 présente, en outre, une impédance faible à la fréquence équivalente du front de tension entre le drain 12D et la source 12S du transistor à protéger 12.

Par conséquent, lors d'une transition rapide de cette tension entre le drain 12D et la source 12S du transistor à protéger 12, le transistor de protection 18 va être piloté par effet de diviseur de tension, c'est-à-dire par répartition de la tension entre le drain 12D et la source 12S du transistor à protéger 12 aux bornes de l'ensemble du condensateur 26 et la résistance 30.

Autrement formulé, le condensateur 26 permet à une partie du courant induit par la montée en tension (dV/dt) aux bornes du transistor à protéger 12 de charger la grille 18G du transistor de protection 18.

Le transistor de protection 18 passe alors dans l'état passant.

Une fois que le transistor de protection 18 est dans cet état, sa résistance d'état passant se retrouve en parallèle de la capacité C_{GS} du transistor 12 (entre la grille 12G et la source 12S). Il en résulte que l'impédance entre la grille 12G et la source 12S est diminuée. De ce fait, la tension entre la grille 12G et la source 12S diminue par un effet de pont diviseur. En effet, le ratio d'impédance Z_grille-drain/Z_grille-source augmente (ce rapport étant respectivement le rapport entre l'impédance entre la grille 12G et le drain 12D et celle entre la grille 12G et la source 12S).

Ainsi, une montée en tension rapide vient charger un transistor de protection 18 à travers le condensateur 26. Une fois passant, ce transistor de protection 18 présente un niveau minimum d'élément parasite et permet l'évacuation des charges qui se stockent temporairement dans la capacité grille 12G - source 12S du transistor à protéger 12. La remise en conduction est ainsi évitée malgré la montée en tension rapide.

L'unité de protection 14 utilise donc la vitesse de montée en tension à l'origine du phénomène d'effet Miller pour se déclencher de façon autonome et empêcher la tension grille 12G-source 12S de monter de façon significative.

En outre, l'unité de protection 14 est intégrée de façon monolithique avec le transistor à protéger 12.

Cela permet d'être plus précis dans la mesure où l'action est effectuée de manière synchrone avec l'apparition de l'effet Miller et plus réactif car très peu d'éléments parasites sont présents entre l'unité de protection 14 et avec le transistor à protéger 12.

L'atténuation de l'effet Miller rend le transistor à protéger 12 plus fiable et lui permet également de commuter plus rapidement (dV/dt plus importants) et donc de potentiellement générer moins de pertes en commutation.

En outre, l'unité de protection 14 est passive et n'implique aucun circuit de commande dédié, ce qui rend sa mise en œuvre aisée.

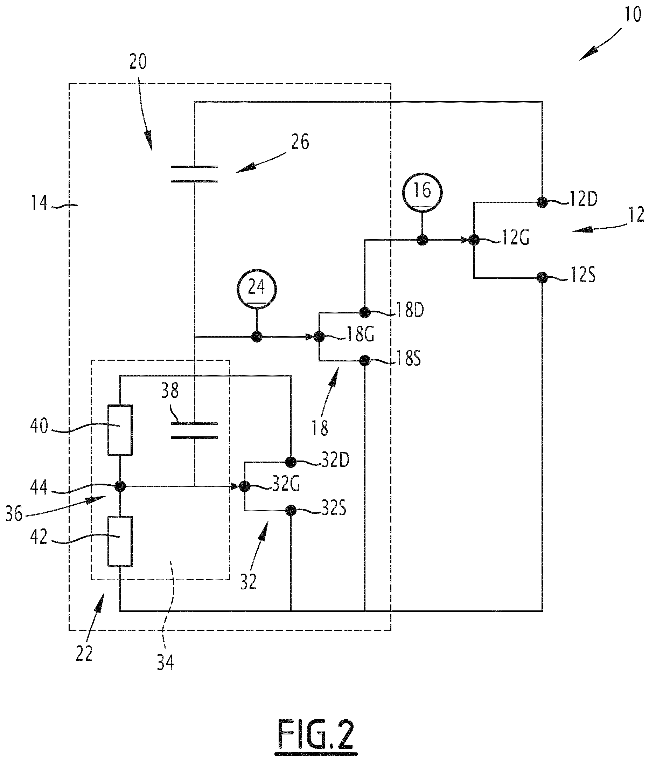

Un autre exemple de commutateur 10 est représenté schématiquement sur la figure 2.

Les éléments communs avec le mode de réalisation de la figure 1 ne sont pas répétés ici, seules les différences sont soulignées dans ce qui suit.

Le circuit de commande 22 est ici différent.

Le circuit de commande 22 est formé par un transistor de commande 32 et une unité de pilotage 34 du transistor de commande 32.

Le transistor de commande 32 comprend également trois électrodes, une grille 32G, un drain 32D et une source 32S.

Le transistor de commande 32 protège la grille 18G du transistor de protection 18.

Le transistor de commande 32 est commandé par l'unité de pilotage 34.Le drain 32D du transistor de décharge 32 est relié à la grille 18G du transistor de protection 18, la grille 32G du transistor de décharge 32 est reliée à l'unité de pilotage 34 et la source 32S du transistor de décharge 32 est reliée à la source des autres transistors 12 et 18.

Pour le cas de la figure 2, l'unité de pilotage 34 comporte un pont de résistances 36 et un condensateur 38.

Le pont de résistances 36 est un ensemble de deux résistances 40 et 42 en série.

La première résistance 40 est reliée d'une part au condensateur 26 du circuit de liaison 20 et d'autre part au point milieu 44 du pont de résistances 36 tandis que la deuxième résistance 42 est reliée d'une part au point milieu 44 du pont de résistances 26 et d'autre part à la source 32S du transistor de décharge 32.

Le point milieu 44 est relié à la grille 32G du transistor de décharge 32.

Le condensateur 38 est branché en parallèle de la première résistance 40.

Plus précisément, le condensateur 38 est relié d'une part au condensateur 26 du circuit de liaison 20 et d'autre part au point milieu 44 du pont de résistances 36.

Le fonctionnement est relativement similaire à celui expliqué pour le cas de la figure 1.

En outre, les deux résistances 40 et 42 servent à décharger la grille 18G du transistor à protéger 18 et forment un diviseur de tension pour piloter le transistor de commande 32 si la tension entre la grille 18G et la source 18S du transistor à protéger devient trop élevée.

Le condensateur 38 permet de changer le ratio du diviseur de tension à haute fréquence et permet au transistor de commande 32 de se déclencher plus vite.

Le commutateur 10 de la figure 2 utilise des composants qu'il est plus aisé de réaliser aujourd'hui que les composants du circuit de commande 22 de la figure 1.

Il en résulte un gain en compacité important. Typiquement, par rapport à une réalisation d'une diode Zener 28 par une pluralité de diodes, une réduction de 50% de la surface occupée sur la puce peut être obtenue.

En outre, en utilisant un transistor de décharge 32 à la place de la diode Zener 28 et en pilotant celui-ci grâce à un pont diviseur résistif (pont de résistances 36) et un condensateur 38, la dynamique à haute fréquence du commutateur 10 est améliorée.

Dans chacun des modes de réalisation précités, le commutateur 10 peut être avantageusement utilisé dans un dispositif électronique, et notamment un dispositif électronique de puissance.

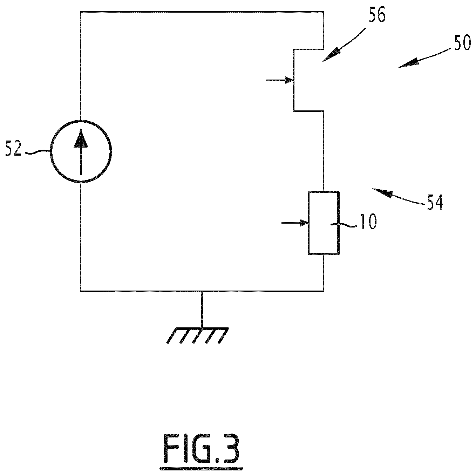

Un exemple de dispositif électronique 50 est représenté sur la figure 3.

Le dispositif électronique 50 est ici un convertisseur utilisé classiquement dans l'électronique de puissance.

Dans l'exemple, le dispositif électronique 50 comporte une source de tension 52 alimentant un bras de pont 54.

Le bras de pont 54 est formé par un transistor 56 et le commutateur 10 en série.

Alternativement, il est possible que le bras de point 54 comporte d'abord le commutateur 10 puis le transistor 56.

## Revendications

1. Commutateur (10) comportant :
- un transistor à protéger (12), le transistor à protéger (12) comprenant une grille (12G), un drain (12D) et une source (12S), et
- une unité de protection (14) contre l'effet Miller, l'unité de protection (14) comprenant :
- un transistor de protection (18), le transistor de protection (18) comportant une grille (18G), un drain (18D) et une source (18S), le drain (18D) du transistor de protection (18) étant relié à la grille (12G) du transistor à protéger (12), la source (18S) du transistor de protection (18) étant reliée à la source (12S) du transistor à protéger (12),
- un circuit de liaison (20), le circuit de liaison (20) étant un filtre passe-haut, le circuit de liaison (20) étant disposé entre la grille (18G) du transistor de protection (18) et le drain (12D) du transistor à protéger (12), et
- un circuit de commande (22), le circuit de commande (22) étant intercalé entre la grille (18G) du transistor de protection (18) et la source (12S) du transistor à protéger (12), le circuit de commande (22) étant formé par un transistor de décharge (32) et une unité de pilotage (34) du transistor de décharge (32), le transistor de décharge (32) présentant un drain (32D) connecté à la grille (18G) du transistor de protection (18) et une source (32S) connectée à la source (12S) du transistor à protéger (12),
le commutateur (10) étant **caractérisé en ce que** l'unité de pilotage (34) comporte un pont de résistances (36) comprenant un point milieu (44), une première résistance (40) et une deuxième résistance (42), l'unité de pilotage (34) comportant également un condensateur (38) en parallèle de la première résistance (40), le point milieu (44) étant relié à la grille (32G) du transistor de décharge (32).

2. Commutateur selon la revendication 1, dans lequel le circuit de liaison (20) est un condensateur (26).

3. Commutateur selon la revendication 1 ou 2, dans lequel le transistor à protéger (12) est réalisé en nitrure de gallium ou en carbure de silicium.

4. Commutateur selon l'une quelconque des revendications 1 à 3, dans lequel l'unité de protection (14) et le transistor à protéger (12) sont réalisés sur une même puce.

5. Commutateur selon l'une quelconque des revendications 1 à 4, dans lequel chaque transistor (12, 18) présente une dimension, le rapport entre la dimension du transistor de protection (18) et la dimension du transistor à protéger (12) étant inférieur ou égal à 0,1.

6. Dispositif électronique (50) comportant un commutateur (10) selon l'une quelconque des revendications 1 à 5.

7. Dispositif électronique selon la revendication 6, dans lequel le dispositif électronique (50) comporte, en outre, une source de tension (52) et un bras de pont (54) formé par un transistor (56) et le commutateur (10).

## Patentansprüche

1. Schalter (10), aufweisend:
- einen zu schützenden Transistor (12), wobei der zu schützende Transistor (12) ein Gate (12G), einen Drain (12D) und eine Source (12S) umfasst, und
- eine Schutzeinheit (14) gegen den Miller-Effekt, wobei die Schutzeinheit (14) umfasst:
- einen Schutztransistor (18), wobei der Schutztransistor (18) ein Gate (18G), einen Drain (18D) und eine Source (18S) aufweist, wobei der Drain (18D) des Schutztransistors (18) mit dem Gate (12G) des zu schützenden Transistors (12) verbunden ist, wobei die Source (18S) des Schutztransistors (18) mit der Source (12S) des zu schützenden Transistors (12) verbunden ist,
- eine Verbindungsschaltung (20), wobei die Verbindungsschaltung (20) ein Hochpassfilter ist, wobei die Verbindungsschaltung (20) zwischen dem Gate (18G) des Schutztransistors (18) und dem Drain (12D) des zu schützenden Transistors (12) angeordnet ist, und
- eine Steuerschaltung (22), wobei die Steuerschaltung (22) zwischen dem Gate (18G) des Schutztransistors (18) und der Source (12S) des zu schützenden Transistors (12) geschaltet ist, wobei die Steuerschaltung (22) von einem Entladungstransistor (32) und einer Steuereinheit (34) für den Entladungstransistor (32) gebildet ist, wobei der Entladungstransistor (32) einen Drain (32D) aufweist, der mit dem Gate (18G) des Schutztransistors (18) verbunden ist und eine Source (32S), die mit der Source (12S) des zu schützenden Transistors (12) verbunden ist,
wobei der Schalter (10) **dadurch gekennzeichnet ist, dass** die Steuereinheit (34) eine Widerstandsbrücke (36) aufweist, die einen Mittelpunkt (44), einen ersten Widerstand (40) und einen zweiten Widerstand (42) umfasst, wobei die Steuereinheit (34) ebenfalls einen Kondensator (38) parallel zum ersten Widerstand (40) aufweist, wobei der Mittelpunkt (44) mit dem Gate (32G) des Entladungstransistors (32) verbunden ist.

2. Schalter nach Anspruch 1, wobei die Verbindungsschaltung (20) ein Kondensator (26) ist.

3. Schalter nach Anspruch 1 oder 2, wobei der zu schützende Transistor (12) aus Galliumnitrid oder Siliziumkarbid hergestellt ist.

4. Schalter nach einem der Ansprüche 1 bis 3, wobei die Schutzeinheit (14) und der zu schützende Transistor (12) auf demselben Chip ausgebildet sind.

5. Schalter nach einem der Ansprüche 1 bis 4, wobei jeder Transistor (12, 18) eine Abmessung aufweist, wobei das Verhältnis zwischen der Abmessung des Schutztransistors (18) und der Abmessung des zu schützenden Transistors (12) kleiner oder gleich 0,1 ist.

6. Elektronische Vorrichtung (50), die einen Schalter (10) nach einem der Ansprüche 1 bis 5 aufweist.

7. Elektronische Vorrichtung nach Anspruch 6, wobei die elektronische Vorrichtung (50) ferner eine Spannungsquelle (52) und einen Brückenarm (54) umfasst, der von einem Transistor (56) und dem Schalter (10) gebildet wird.

## Claims

1. A switch (10) comprising:
- a transistor to be protected (12), the transistor to be protected (12) comprising a gate (12G), a drain (12D) and a source (12S), and
- a protection unit (14) against the Miller effect, the protection unit (14) comprising:
- a protection transistor (18), the protection transistor (18) having a gate (18G), a drain (18D) and a source (18S), the drain (18D) of the protection transistor (18) being connected to the gate (12G) of the transistor (12) to be protected, the source (18S) of the protection transistor (18) being connected to the source (12S) of the transistor (12) to be protected,
- a linking circuit (20), the linking circuit (20) being a high-pass filter, the linking circuit (20) being arranged between the gate (18G) of the protection transistor (18) and the drain (12D) of the transistor to be protected (12), and
- a control circuit (22), the control circuit (22) being interposed between the gate (18G) of the protection transistor (18) and the source (12S) of the transistor to be protected (12), the control circuit (22) being formed by a discharge transistor (32) and a drive unit (34) of the discharge transistor (32), the discharge transistor (32) comprising a drain (32D) connected to the gate (18G) of the protection transistor (18) and a source (32S) connected to the protection transistor (18),
the switch (10) being **characterized in that** the drive unit (34) has a resistor bridge (36) comprising a midpoint (44), a first resistor (40) and a second resistor (42), the drive unit (34) also having a capacitor (38) in parallel with the first resistor (40), the midpoint (44) being connected to the gate (32G) of the discharge transistor (32).

2. The switch according to claim 1, wherein the linking circuit (20) is a capacitor (26).

3. The switch according to claim 1 or 2, wherein the transistor to be protected (12) is made of gallium nitride or silicon carbide.

4. The switch according to any one of claims 1 to 3, wherein the protection unit (14) and the transistor to be protected (12) are realised on the same chip.

5. The switch according to any one of claims 1 to 4, wherein each transistor (12, 18) has a size, the ratio between the size of the protection transistor (18) and the size of the transistor to be protected (12) being less than or equal to 0.1.

6. An electronic device (50) comprising a switch (10) according to any of claims 1 to 5.

7. The electronic device according to claim 6, wherein the electronic device (50) further comprises a voltage source (52) and a bridge arm (54) formed by a transistor (56) and the switch (10).
